# FASCICULE DE BREVET EUROPEEN

(11) **EP 2 812 127 B1**
(45) Date de publication et mention de la délivrance du brevet: **28.12.2016**
(21) Numéro de dépôt: 13704918.5
(22) Date de dépôt: 08.02.2013
(51) Int. Cl.: B05D 1/20

(54) **PROCÉDÉ DE TRANSFERT D'OBJETS SUR UN SUBSTRAT À L'AIDE D'UN FILM COMPACT DE PARTICULES, AVEC UNE ÉTAPE DE RÉALISATION DE CONNECTEURS SUR LES OBJETS**
VERFAHREN ZUR ÜBERTRAGUNG VON OBJEKTEN AUF EIN SUBSTRAT MIT EINEM KOMPAKTEN PARTIKELFILM EINSCHLIESSLICH EINES SCHRITTS ZUR HERSTELLUNG VON VERBINDERN AUF DEN OBJEKTEN
METHOD FOR TRANSFERRING OBJECTS ONTO A SUBSTRATE USING A COMPACT PARTICLE FILM, INCLUDING A STEP OF PRODUCING CONNECTORS ON THE OBJECTS

(30) Priorité: 10.02.2012 FR 1251257
(43) Date de publication de la demande: 17.12.2014
(73) Titulaire: Commissariat à l'Énergie Atomique et aux Énergies Alternatives, 75015 Paris (FR)
(72) Inventeur: DELLEA, Olivier, F-42350 La Talaudiere (FR); CORONEL, Philippe, F-38530 Barraux (FR); DREUILLES, Nicolas, F-38000 Grenoble (FR); FUGIER, Pascal, F-38190 Bernin (FR)
(74) Mandataire: Brevalex
(86) Numéro de dépôt international: PCT/EP2013/052500
(87) Numéro de publication internationale: WO 2013/117678

(56) Documents cités:
- WO-A1-03/095108
- WO-A2-01/89716
- US-A- 4 888 209
- US-A1- 2005 281 944

## Description

### DOMAINE TECHNIQUE

L'invention se rapporte au domaine du transfert d'objets sur un substrat, de préférence en défilement, afin de fabriquer des dispositifs variés.

Il s'agit en particulier de fabriquer des dispositifs à caractère hybride, comme par exemple des capteurs. A titre indicatif, un dispositif hybride associe par définition sur un même substrat des objets ayant diverses fonctions, par exemple électroniques, optiques, électro-optiques, piézo-électriques, thermoélectriques, mécaniques, etc.

Les objets à déposer/transférer sont par exemple :
- des composants électroniques actifs, tels que des transistors, microprocesseurs, circuits intégrés, etc. ;
- des composants passifs de l'électronique, comme des résistances, capacités, diodes, photodiodes, bobines, pistes conductrices, préformes de soudure, etc. ;
- des composants optiques, tels que des lentilles, microlentilles, réseaux de diffraction, filtres, etc. ;
- des piles, micro-piles, micro-batteries, photo-détecteurs, cellules solaires, système RFID, etc. ;
- des particules ou agrégats nano ou micrométriques, actifs ou passifs, par exemple du type oxydes, polymères, métaux, semi-conducteurs, Janus (particules ayant deux faces de natures ou propriétés différentes), nanotubes, etc.

Plus particulièrement, l'invention concerne le transfert d'objets dont les dimensions s'étendent :
- pour les composants : de l'échelle microscopique (quelques dizaines de microns), à l'échelle macroscopique (plus d'une dizaine de centimètres) ; et
- pour les particules et agrégats : du nanomètre à plusieurs centaines de microns.

L'invention se rapporte également au domaine de l'électronique, selon des architectures deux dimensions et trois dimensions.

### ÉTAT DE LA TECHNIQUE ANTÉRIEURE

Pour la fabrication de tels dispositifs, il a récemment été développé une technique de transfert d'objets sur un substrat, via un convoyeur liquide. Néanmoins, ces dispositifs nécessitent généralement la présence de connecteurs, qu'ils soient électriques, thermiques, optiques, ou mécaniques. Ces connecteurs permettent pour certains de relier deux objets du dispositif, et/ou servent de raccord destinés à coopérer avec un élément extérieur au dispositif.

Néanmoins, les techniques usuelles pour réaliser de tels connecteurs (brasage, soudure par écrasement de boule, soudure en coin, etc.) ne s'avèrent pas adaptées lorsqu'il s'agit de transférer des objets sur un substrat par l'intermédiaire d'un convoyeur liquide.

### EXPOSÉ DE L'INVENTION

L'invention a donc pour but de remédier au moins partiellement à l'inconvénient mentionné ci-dessus. Pour ce faire, l'invention a pour objet un procédé de transfert d'objets sur un substrat, de préférence en défilement, mis en oeuvre à l'aide d'une zone de transfert contenant un liquide porteur formant convoyeur, lesdits objets étant maintenus par un film compact de particules flottant sur le liquide porteur de cette zone de transfert, au sein de laquelle lesdits objets sont déplacés avec ledit film de particules de manière à être transférés sur le substrat lorsqu'ils atteignent la sortie.

De plus, le procédé comprend également la réalisation d'au moins un connecteur en contact avec au moins l'un desdits objets, ledit connecteur étant réalisé à l'aide d'une substance comprenant un composé polymérisable, mise au contact dudit objet agencé au sein de la zone de transfert, puis par polymérisation de ladite substance.

Cette technique de fabrication des connecteurs se révèle simple à mettre en oeuvre, et tout à fait adaptée au contexte de transfert d'objets par convoyeur liquide. En particulier, lors de son application, toute substance polymérisable est capable de s'adapter aux éventuelles différences de niveaux entre les différents objets reliés et/ou entre les objets et le film de particules.

Le contact du connecteur avec un objet peut être par exemple au-dessus ou en dessous de cet objet, comme cela sera expliqué ci-après.

En outre, le/les connecteurs réalisés peuvent être des connecteurs électriques, thermiques, optiques, piézoélectriques ou mécaniques, reliant deux ou plusieurs objets, ou bien destinés à coopérer avec un élément extérieur au dispositif fabriqué. Lorsqu'ils relient deux ou plusieurs objets, ces derniers sont par exemple positionnés dans le plan du film de particules.

La polymérisation s'effectue par toute technique réputée appropriée par l'homme du métier, de préférence thermique ou optique. Elle est complète ou partielle lorsque l'objet se trouve encore sur le liquide porteur, ou, alternativement, s'effectue entièrement en dehors du liquide porteur, après le transfert sur le substrat. De préférence, au moment du transfert sur le substrat, la substance, polymérisée ou non, reste suffisamment souple de manière à supporter une éventuelle flexion lors du passage de la zone de transfert au substrat.

En fonction des besoins rencontrés et de la nature des connecteurs, ceux-ci peuvent être réalisés par des cordons, continus ou discontinus, ou des points, le diamètre des cordons et des points pouvant avoisiner quelques dizaines de microns à plusieurs millimètres.

Selon un mode de réalisation préféré, au moins un connecteur est réalisé entre au moins deux desdits objets, à l'aide de ladite substance comprenant un composé polymérisable, appliquée sur le film de particules de manière à relier les deux objets espacés l'un de l'autre au sein de la zone de transfert, puis par polymérisation de ladite substance. Dans ce mode, le connecteur peut relier des surfaces quelconques des deux objets, ceux-ci étant maintenus par le film dans la zone de transfert, selon différentes formes qui seront décrites ci-après.

Selon un autre mode de réalisation préféré, au moins un connecteur est réalisé entre au moins deux desdits objets destinés à être empilés l'un sur l'autre, à l'aide de ladite substance comprenant un composé polymérisable, appliquée sur l'un desdits objets agencé au sein de la zone de transfert, puis par polymérisation de ladite substance. Cette technique est particulièrement intéressante dans le cadre de la réalisation de dispositifs en trois dimensions à partir de plusieurs objets empilés et connectés les uns aux autres.

Dans un autre mode de réalisation préféré, le connecteur est prévu pour être en contact avec un élément extérieur au dispositif, et ne relie donc pas deux objets placés dans la zone de transfert comme pour les modes précédents. A cet égard, il est noté que l'ensemble des modes de réalisation présentés sont combinables, à savoir qu'un même objet placé dans la zone de transfert peut être équipé de différentes sortes de connecteurs.

Dans un cas particulier du dernier mode de réalisation décrit, ledit substrat est pourvu d'au moins un orifice traversant, destiné à loger au moins un connecteur réalisés entre la surface inférieure d'un objet et le film compact de particules. Le connecteur réalisé de la sorte devient donc accessible sur la surface opposée du substrat, ce qui permet de l'assimiler à un connecteur vertical, traversant, généralement dénommé « TSV » (de l'anglais « Through Silicon Via »).

Comme évoqué ci-dessus, quel que soit le mode de réalisation envisagé, chaque connecteur est un connecteur électrique, thermique, optique, piézoélectrique ou mécanique, plusieurs de ces fonctions pouvant bien entendu être cumulées.

De préférence, au moins un connecteur épouse une surface supérieure d'au moins l'un des objets.

Alternativement ou simultanément, un connecteur épouse une surface inférieure d'au moins l'un des objets, en étant interposé entre cette surface inférieure et le film compact de particules.

De préférence, ladite substance se présente sous la forme d'un liquide ou d'une pâte.

De préférence, ladite substance présente un caractère hydrophobe, et de préférence aussi à l'état solide polymérisé du connecteur. De manière plus générale, tenant notamment compte des cas où le liquide porteur n'est pas de l'eau, il est noté que la substance comprenant le composé polymérisable se révèle non-miscible avec le liquide porteur.

De préférence, ladite substance est à base de résine silicone, de résine époxy, et/ou de résine polyuréthane.

De préférence, afin de donner au connecteur sa fonction première, en particulier pour le rendre électriquement conducteur et/ou thermiquement conducteur, ladite substance comprend au moins certaines particules prises parmi les matériaux suivants :
- noir de carbone ;
- nanotubes de carbone ;
- graphène
- fibres, telles que des fibres de carbone, d'acier d'aluminium, de cuivre ;
- poudres métalliques ; et
- des oxydes de métaux.

Par ailleurs, il est rappelé qu'avant ou après la réalisation du connecteur, les/les objets sont placés puis maintenus par le film compact de particules flottant sur le liquide porteur de la zone de transfert, au sein de laquelle lesdits objets sont déplacés avec ledit film de particules de manière à être transférés sur le substrat lorsqu'ils atteignent la sortie.

Le concept repose ici sur l'utilisation d'un film compact de particules pour maintenir en position les objets sur le liquide porteur, puis pour convoyer ces mêmes objets jusqu'au substrat. Le transfert des objets peut par conséquent s'effectuer avec précision sur le substrat, de manière simple, fiable, et répétitive. De plus, le dépôt des objets muni des connecteurs ne s'effectuant pas directement sur le substrat, il est facilement possible de réajuster leur position dans la zone de transfert, avant leur dépôt sur ce même substrat.

Le film compact de particules s'apparente donc à une plate-forme permettant d'accueillir des objets homogènes ou hétérogènes, nanoscopiques, microscopiques, millimétrique ou macroscopiques. Cette plate-forme peut elle-même être composée d'un ensemble homogène ou hétérogène de particules nanométriques ou microscopiques, de préférence de compositions différentes de celles des objets à transférer. Comme cela sera détaillé ci-après, les objets à transférer peuvent être intégrés à cette plate-forme, ou simplement être agencés sur celle-ci.

En effet, selon une première possibilité, au moins l'un des objets à transférer est placé dans la zone de transfert, en flottaison sur le liquide porteur formant convoyeur, de manière à être entouré par le film compact de particules. Ici, les objets sont maintenus en position par les particules qui les enserrent à leur périphérie. Les objets présentent ainsi une surface inférieure directement en contact avec le liquide porteur.

Selon une seconde possibilité, au moins l'un des objets à transférer est placé dans la zone de transfert sur le film compact de particules préalablement formé, de manière à créer, dans le liquide porteur, un enfoncement des particules qui le supportent.

Dans cette seconde solution, les particules enfoncées situées sous chaque objet définissent alors une rupture de niveau avec les particules environnantes du film. Ce sont alors ces mêmes particules environnantes qui enserrent la périphérie de chaque objet, permettant ainsi de les maintenir en position et de les transporter d'une façon analogue à celle de la première solution.

Bien entendu, des objets peuvent être placés dans le film de particules selon la première solution et d'autres selon la seconde solution, sans sortir du cadre de l'invention.

De plus, comme évoqué ci-dessus, le film compact de particules peut être formé de particules hétérogènes. Ces particules peuvent aussi être fonctionnalisées à leur surface pour que se forme un lien physique entre particules, par exemple de type polymère, afin de renforcer la cohésion et donc la portance du film compact.

De préférence, le rapport entre la grande dimension des particules du film compact et celle des objets à transférer est compris entre 10⁴ et 10⁸. A titre d'exemple, les particules formant le film compact peuvent présenter une grande dimension de l'ordre de 1 nm à 500 µm, tandis que les objets convoyés par ce film peuvent quant à eux présenter une grande dimension allant jusqu'à environ 30 cm.

De préférence, les particules du film compact sont des billes de silice d'environ 1 µm de diamètre. Il est néanmoins noté que le film peut être hétérogène, à savoir comporter des billes de tailles différentes.

De préférence, chaque objet à transférer présente une grande dimension supérieure à 0,2 cm, et de préférence inférieure à 30 cm. Cette dernière valeur peut être adaptée en fonction de la largeur de la zone de transfert. En effet, la grande dimension de chaque objet peut atteindre une valeur proche de la largeur précitée. Des objets de taille micrométrique ou nanométrique peuvent également être déposés/transférés, sans sortir du cadre de l'invention.

De préférence, chaque objet à transférer présente au moins une partie à caractère hydrophobe. Cela est prévu de manière à assurer la flottaison de l'objet, en plaçant cette partie au contact du liquide porteur. Cette face de contact avec le liquide peut être totalement hydrophobe ou comporter un agencement de zones hydrophiles et hydrophobes, utiles au dispositif final.

L'objet à transférer peut être de toute forme, non-nécessairement plane, éventuellement présentant un ou plusieurs rayons de courbure, par exemple inférieur à 5 cm, ou encore intégrant des plots utiles pour la connectique. De même, pour les particules du film, les formes peuvent être variées.

A titre d'exemples indicatifs, chaque objet à transférer peut être un élément pris parmi le groupe des puces en silicium, des micro-batteries, des composants de l'électronique organique, des composants photovoltaïques, LED, PLED, OLED, des éléments métalliques, des piles et micro-piles.

Il est également visé la fabrication de dispositifs complexes comme par exemple des capteurs comprenant des éléments de détections (des particules par exemple), un ou plusieurs systèmes de récupération d'énergie (cellule photovoltaïque, film piézoélectrique, pile à combustible), un système de stockage de l'énergie (micro-batterie), un système de gestion de l'information (puce en Silicium), un système de communication (puce RFID), des éléments de liaison électrique (pistes conductrices), des composants électroniques (résistances, condensateurs), des éléments de soudure (préformes). Les objets nécessaires à l'obtention de ces dispositifs sont alors agencés en conséquence sur le convoyeur liquide, et étant au besoin superposés.

Il est par ailleurs noté que le film compact de particules, dont le concept est par exemple divulgué dans le document Sachin Kinge, "Self-Assembling Nanoparticles at Surfaces and Interfaces", ChemPhysChem 2008, 9, 20-42*,* peut être obtenu à la surface du liquide porteur par toute technique connue de l'homme du métier, par exemple par compression *(Langmuir-Blodgett),* et/ou interaction dipôle-dipôle, et/ou par champ magnétique, etc.

La technique par interaction dipôle-dipôle s'applique pour les particules à facettes, par exemple tétraédriques, cubiques ou encore octaédriques. Avec ces formes, les interactions dipôle-dipôle jouent un rôle important dans l'organisation des particules. Les moments dipolaires sont générés à l'intérieur de ces particules, à cause des différences de polarité entre les facettes.

La technique d'organisation par champ magnétique est employée avec des nanoparticules magnétiques pouvant être ordonnées en utilisant un champ magnétique intense, générant des interactions fortes entre les particules.

La technique par compression est notamment connue du document Lucio Isa et al., "Particle Lithography from Colloidal Self-Assembly at Liquid_Liquid Interfaces", acsnano, VOL. 4 ▪ NO. 10 ▪ 5665-5670 ▪ 2010, du document Markus Retsch, « Fabrication of Large-Area, Transferable Colloidal Monolayers Utilizing Self-Assembly at the Air/Water Interface", Macromol. Chem. Phys. 2009, 210, 230-241*,* ou encore du document Maria Bardosova, « The Langmuir-Blodgett Approach to Making Colloidal Photonic Crystals from Silica Spheres", Adv. Mater. 2010, 22, 3104-3124*.*

Cette technique par compression comprend également la solution à rampe inclinée décrite dans le document CA 2 695 449. Ainsi, le procédé selon l'invention met préférentiellement en oeuvre une rampe inclinée de circulation des particules, rattachée à une entrée de la zone de transfert, et sur laquelle ledit liquide porteur est également destiné à circuler.

Une partie de l'énergie nécessaire à l'ordonnancement des particules en régime normal est alors ici amenée par la rampe inclinée transportant le liquide porteur et les particules. D'autres solutions sont néanmoins possibles, comme la mise en mouvement, à l'aide d'une pompe, du liquide porteur sur un plan horizontal dont la partie aval constitue la zone de transfert des particules. Une autre solution consiste à remplacer la pompe par une soufflerie permettant d'appliquer un flux d'air à la surface du liquide porteur, sur lequel flottent les particules et les objets à transférer. Comme mentionné ci-dessus, d'autres solutions sont néanmoins envisageables, sans sortir du cadre de l'invention, comme un travail de compression des particules via une technique dite « Langmuir-Blodgett ».

Enfin, postérieurement au transfert des particules et des objets sur le substrat, le procédé intègre de préférence une étape de recuit thermique pour faciliter le dépôt et l'adhérence de ces particules et objets sur le substrat.

D'autres avantages et caractéristiques de l'invention apparaîtront dans la description détaillée non limitative ci-dessous.

### BRÈVE DESCRIPTION DES DESSINS

Cette description sera faite au regard des dessins annexés parmi lesquels ;
- la figure 1 montre une installation de transfert selon un mode de réalisation préféré de la présente invention, en coupe schématique prise le long de la ligne I-I de la figure 2 ;
- la figure 2 représente une vue schématique de dessus de l'installation de transfert montrée sur la figure 1 ;
- les figures 3 à 7 représentent différentes étapes d'un procédé de transfert mis en oeuvre à l'aide de l'installation montrée sur les figures précédentes ;

- les figures 7a à 7e schématisent des étapes de réalisation de différents types de connecteurs sur les objets à transférer montrés sur les figures précédentes ;
- les figures 8 et 9 représentent différentes étapes d'un autre procédé de transfert, également mis en oeuvre à l'aide de l'installation montrée sur les figures 1 et 2 ;
- la figure 9a schématise une étape de réalisation d'un connecteur entre deux objets à transférer montrés sur la figure 9 ;
- la figure 10 représente une installation de transfert selon un autre mode de réalisation préféré de la présente invention ; et
- les figures 11a à 11e montrent différentes solutions pour la mise en place des objets dans la zone de transfert.

### EXPOSÉ DÉTAILLÉ DE MODES DE RÉALISATION PRÉFÉRÉS

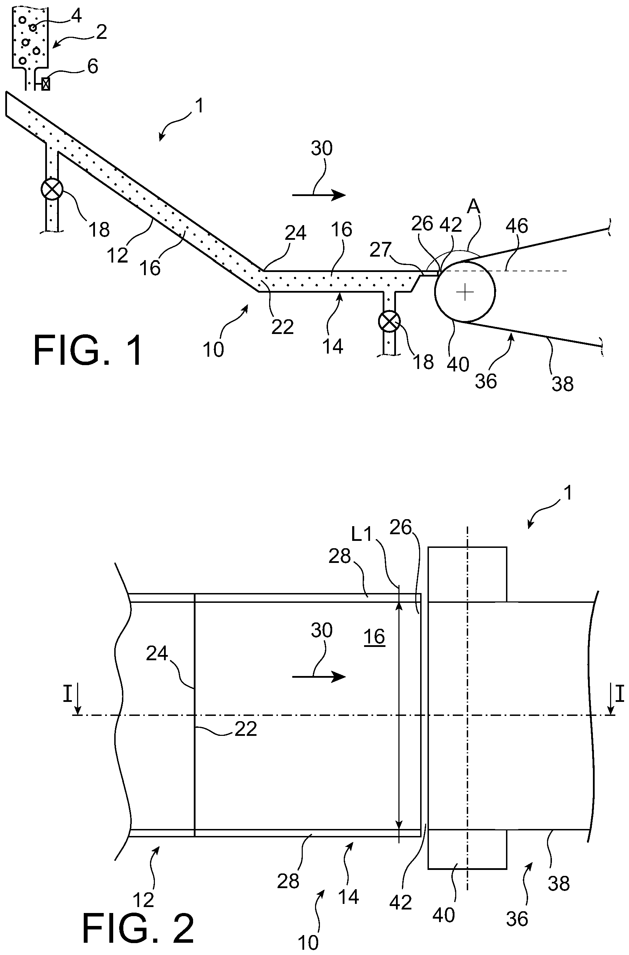

En référence tout d'abord aux figures 1 et 2, on peut apercevoir une installation 1 pour le transfert d'objets sur un substrat, de préférence en défilement. Ce transfert, assimilable à un dépôt, s'effectue à l'aide d'un film compact de particules.

L'installation 1 comporte un dispositif 2 de dispense de particules 4, dont la taille peut être comprise entre quelques nanomètres et plusieurs centaines de micromètres. Les particules, de préférence de forme sphérique, peuvent par exemple être des particules de silice. D'autres particules d'intérêt peuvent être faites de métal ou d'oxyde de métal comme le Platine, le TiO2, de polymère comme le polystyrène ou le PMMA, de carbone, etc.

Plus précisément, dans le mode de réalisation préféré, les particules sont des sphères de silice d'environ 1 µm de diamètre, stockées en solution dans le dispositif de dispense 2. La proportion du milieu est d'environ 7 g de particules pour 200 ml de solution, ici du butanol. Naturellement, pour des raisons de clarté, les particules représentées sur les figures adoptent un diamètre supérieur à leur diamètre réel.

Le dispositif de dispense 2 présente une buse d'injection 6 commandable, d'environ 500 µm de diamètre.

L'installation comporte également un convoyeur liquide 10, intégrant une rampe inclinée 12 de circulation des particules, et une zone de transfert 14 sensiblement horizontale, voire présentant une légère inclinaison de façon à favoriser la vidange de l'installation, le cas échéant. L'extrémité haute de la rampe inclinée est prévue pour recevoir les particules injectées depuis le dispositif de dispense 2. Cette rampe est droite, inclinée d'un angle compris entre 5 et 60°, de préférence entre 10 et 30°, permettant aux particules d'être acheminées vers la zone de transfert 14. De plus, un liquide porteur 16 circule sur cette rampe 12, jusque dans la zone de transfert. Ce liquide 16 peut d'ailleurs être re-circulé à l'aide d'une ou deux pompes 18, entre la zone de transfert 14 et l'extrémité haute de la rampe. Il s'agit ici de préférence d'une eau dé-ionisée, sur laquelle les particules 4 peuvent flotter. Néanmoins, on peut privilégier un liquide neuf via un circuit de circulation ouvert. Il peut aussi s'agir d'une association de plusieurs liquides non-miscibles.

L'extrémité basse de cette même rampe est raccordée à une entrée de la zone de transfert de particules 14. Cette entrée 22 se situe au niveau d'une ligne d'inflexion 24 matérialisant la jonction entre la surface du liquide porteur présent sur le plan incliné de la rampe 12, et la surface du liquide porteur présent sur la partie horizontale de la zone de transfert 14.

L'entrée de particules 22 est espacée d'une sortie de particules 26 à l'aide de deux rebords latéraux 28 retenant le liquide porteur 16 dans la zone 14. Ces rebords 28, en regard et à distance l'un de l'autre, s'étendent parallèlement à une direction principale d'écoulement du liquide porteur et des particules dans l'installation, cette direction étant schématisée par la flèche 30 sur les figures 1 et 2. La zone 14 prend par conséquent la forme d'un couloir ou d'un chemin ouvert à son entrée et à sa sortie, même si d'autres géométries pourraient être adoptées, sans sortir du cadre de l'invention.

Le fond de la partie aval de la zone de transfert présente un plateau 27 légèrement incliné vers l'amont par rapport à la direction horizontale, par exemple d'une valeur de l'ordre de 5 à 10°. C'est l'extrémité aval de ce même plateau 27, également dénommé « blade », qui définit en partie la sortie des particules 26.

L'installation 1 est également pourvue d'un convoyeur de substrat 36, destiné à mettre le substrat 38 en défilement. Ce substrat peut être rigide ou souple. Dans ce dernier cas, il peut être mis en mouvement sur un rouleau 40 dont l'axe est parallèle à la sortie 26 de la zone 14, à proximité de laquelle il se situe. En effet, le substrat 38 est destiné à défiler de manière très rapprochée de la sortie 26, afin que les particules atteignant cette sortie puisse être transférées aisément sur ce substrat, via un pont capillaire 42, également dénommé ménisque, qui le relie au liquide porteur 16. Alternativement, le substrat peut être au contact directement de la zone de transfert, sans sortir du cadre de l'invention. Le pont capillaire mentionné ci-dessus n'est alors plus requis.

Dans l'exemple montré sur les figures, la largeur du substrat correspond à la largeur de la zone 14 et de sa sortie 26. Il s'agit d'une largeur L1 qui correspond aussi à la largeur maximale du film de particules qu'il est possible de déposer sur le substrat. Cette largeur peut être de l'ordre de 25 à 30 cm. La largeur du substrat sur lequel doivent être déposées les particules peut cependant être inférieure à la largeur L1.

Le pont capillaire 42 est assuré entre le liquide porteur 16 qui se situe au niveau de la sortie 26, et une partie du substrat 38 épousant le rouleau de guidage / d'entraînement 40.

De préférence, l'angle saillant A, formé entre la direction horizontale 46 et la partie du substrat 38 sur laquelle le film de particules et les objets doivent se déposer, est supérieure à 160°, et encore plus préférentiellement proche de 180°, par exemple de l'ordre de 175°.

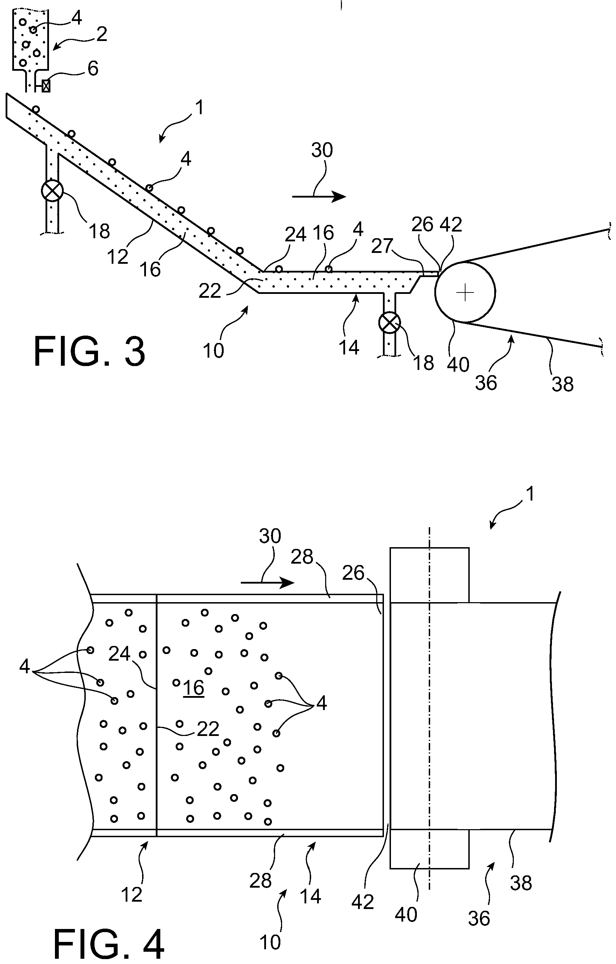

Un procédé de transfert d'objets va maintenant être décrit en référence aux figures 3 à 7e.

Tout d'abord, la buse d'injection 6 est activée pour débuter la dispense des particules 4 sur la rampe 12. Il s'agit de mettre en oeuvre une étape initiale de remplissage de la zone de transfert 14, par les particules 4, avec le liquide porteur 16 déjà au niveau requis dans la zone 14.

Durant cette phase d'amorçage, les particules dispensées par le dispositif 2 circulent sur la rampe 12, puis pénètrent dans la zone 14 dans laquelle elles se dispersent, comme cela a été schématisé sur les figures 3 et 4.

Au fur et à mesure que les particules 4 sont injectées sur la rampe 12 et pénètrent dans la zone de transfert 14, elles viennent en butée contre le substrat 38, puis le front amont de ces particules a tendance à se décaler vers l'amont, en direction de la ligne d'inflexion 24. L'injection de particules est poursuivie même après que ce front amont ait dépassé la ligne 24, afin qu'il remonte sur la rampe inclinée 12.

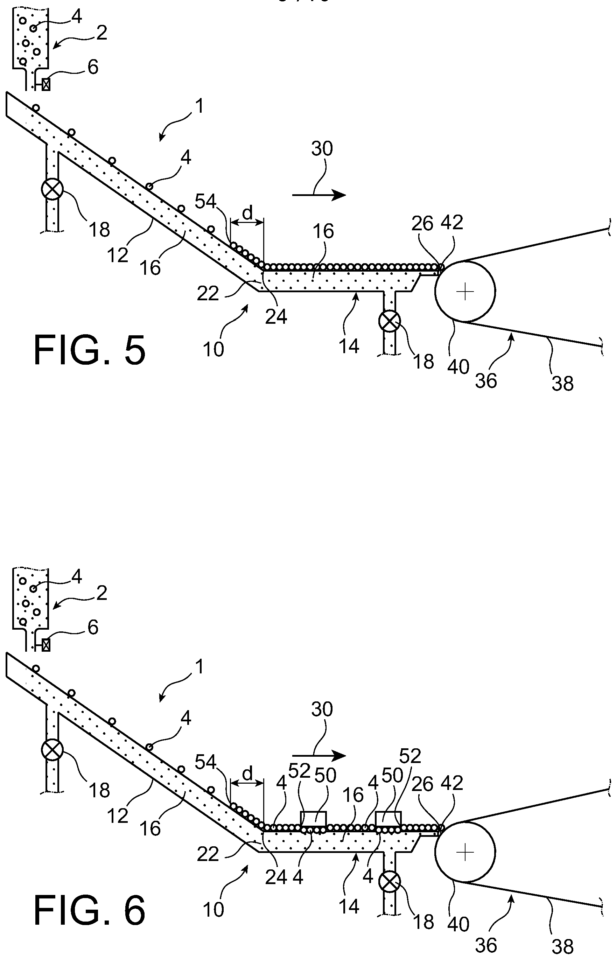

Effectivement, il est fait en sorte que le front amont de particules 54 remonte sur la rampe 12 de manière à ce qu'il se situe à une distance horizontale « d » donnée de la ligne d'inflexion 24, comme montré sur la figure 5. La distance « d » peut être de l'ordre de 30 mm.

A cet instant, les particules 4 sont ordonnées dans la zone de transfert et sur la rampe 12, sur laquelle elles s'ordonnent automatiquement, sans assistance, grâce notamment à leur énergie cinétique et aux forces capillaires mises à profit au moment de l'impact sur le front 54. L'ordonnancement est tel que le film compact obtenu présente une structure dite « hexagonale compacte », dans laquelle chaque particule 4 est entourée et contactée par six autres particules 4 en contact entre elles. Il est alors indifféremment parlé de film compact de particules, ou de film de particules ordonnées.

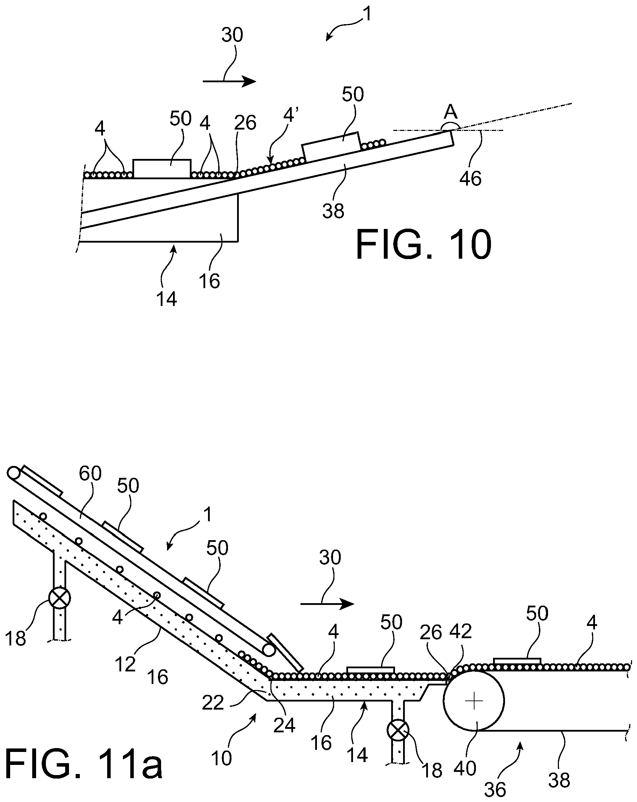

Une fois que les particules ordonnancées 4 recouvrent l'intégralité du liquide porteur situé dans la zone de transfert 14, les objets 50 à déposer/transférer peuvent être mis en place au-dessus du film, à des emplacements prédéterminés. Cette mise en place peut être réalisée à l'aide d'outils de manipulation ou de préhension conventionnels adaptés à la nature, la forme et la dimension des objets, comme des pinces, selon une technique dite de *« pick and place* ». D'autres solutions sont envisagées, comme celle qui sera décrite ultérieurement en référence aux figures 11a à 11e.

Comme le montre la figure 6, le positionnement des objets 50 sur le film a pour conséquence de créer un enfoncement des particules 4 qui supportent ces mêmes objets, dans le liquide porteur 16 formant convoyeur. Il est noté que les objets peuvent être tenus à la surface du liquide par la tension superficielle de ce liquide, le film de particules modifiant la tension superficielle du liquide pouvant alors contribuer, dans une certaine mesure, à la tenue de ces objets.

Plus précisément, les particules enfoncées 4 situées sous chaque objet 50 définissent alors une rupture de niveau 52 avec les autres particules environnantes 4. Ce sont alors ces mêmes particules environnantes qui enserrent la périphérie de chaque objet 50, permettant ainsi de les maintenir en position les uns par rapport aux autres, ainsi que par rapport à la structure fixe de la zone de transfert.

Chaque rupture de niveau 52 est de préférence inférieure au diamètre des particules 4, de sorte que les particules enfoncées 4 soient également retenues et maintenues par les particules environnantes.

La mise en position des premiers objets, ainsi que des suivants, s'effectue préférentiellement sans arrêter le flux de particules provenant de la rampe 12, bien qu'il puisse en être autrement, sans sortir du cadre de l'invention.

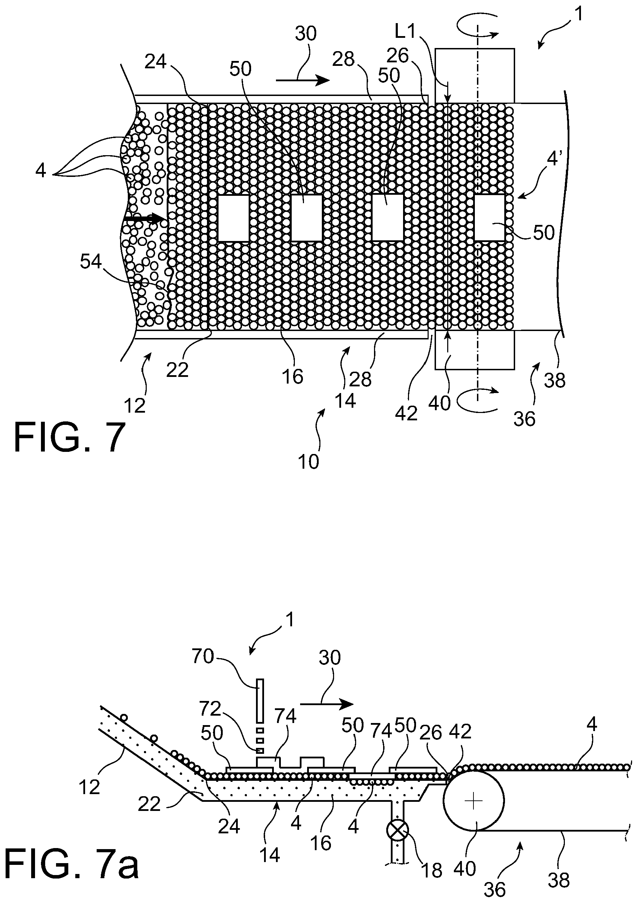

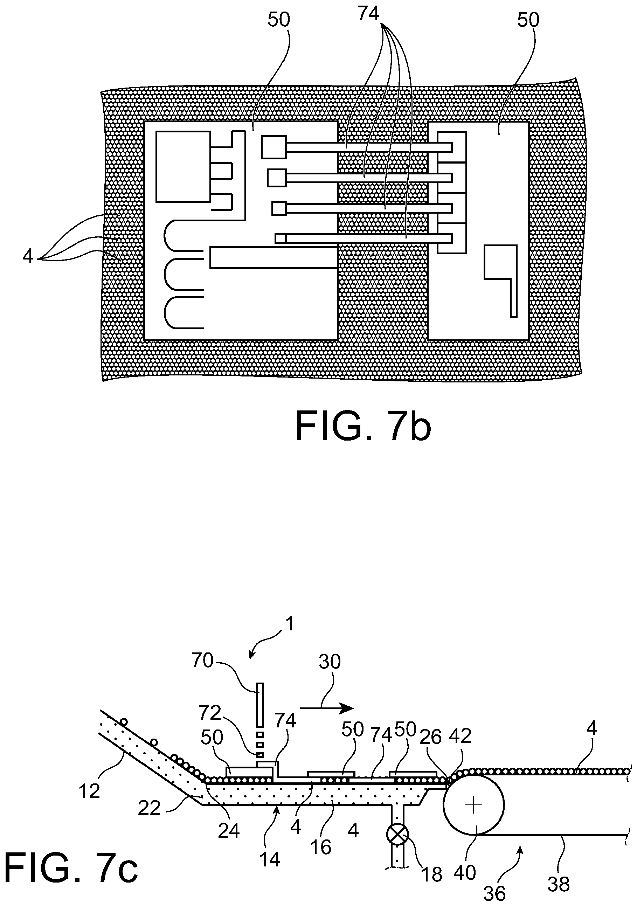

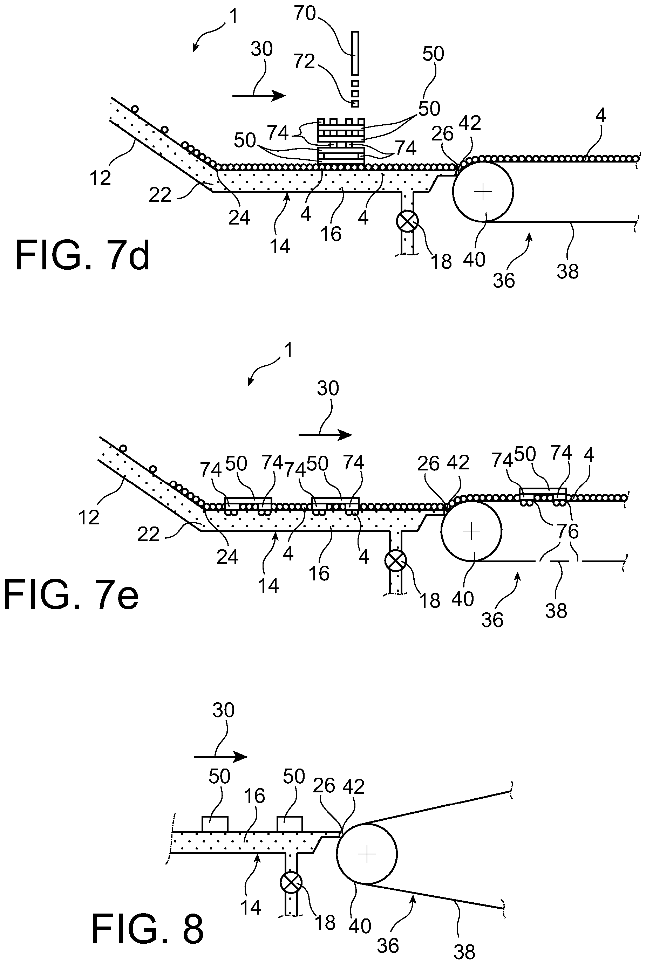

La figure 7 montre l'état de l'installation après le déclenchement du mouvement du substrat 38, initié dès que le front 54 a atteint le niveau requis représenté sur la figure 5. Le film de particules et les objets portés, maintenus et convoyés par ce dernier, se déposent alors sur le substrat 38 en empruntant le pont capillaire 42, à la manière de celle décrite dans le document CA 2 695 449. Auparavant, comme cela a été schématisé sur la figure 7a et 7b, le procédé comprend une étape de réalisation d'un ou plusieurs connecteurs sur les objets 50.

Pour ce faire, une buse 70 de dispense d'une substance 72, comprenant un composé polymérisable, permet de déposer cette substance à l'endroit désiré dans la zone de transfert 14. Dans le mode de réalisation montré sur les figures 7a et 7b, il est prévu que chaque connecteur 74 obtenu relie deux objets 50 directement consécutifs, posés sur le film 4 dans la zone de transfert. Sur ces figures, le connecteur de gauche 74 relie la surface supérieure d'un premier objet et la surface supérieure d'un second objet, en épousant la partie du film de particules 4 située entre ces deux objets 50. Toute substance polymérisable étant capable de s'adapter à une topographie complexe, avec des différences de niveaux, cette substance se révèle alors parfaitement adaptée à l'application visée dans laquelle les objets 50 sont susceptibles de former des niveaux avec le film 4.

Le connecteur de droite 74 relie quant à lui la surface inférieure du second objet et la surface inférieure d'un troisième objet, en épousant également la partie du film de particules 4 située entre ces deux objets 50. Pour ce faire, la substance est déposée d'abord sur le film de billes, avant le dépôt des objets à relier, contrairement au cas précédent où ce sont les objets 50 qui sont préalablement mis en place dans la zone de transfert 14. Ainsi, la substance se trouve agencée sur le film de particules 4, entre ce dernier et la surface inférieure de l'objet 50 concerné.

Comme cela est le mieux visible sur la figure 7b, les connecteurs prennent ici la forme de cordons continus, mais pourraient alternativement être des points. Le diamètre des cordons est de préférence compris entre quelques dizaines de microns et plusieurs millimètres.

Le composé polymérisable est par exemple une résine silicone, une résine époxy, et/ou une résine polyuréthane. La polymérisation s'effectue de manière classique, par exemple par voie thermique et/ou optique, et s'opère de préférence, au moins en partie, lorsque les objets au contact de cette substance sont encore dans la zone de transfert, pas encore déposés sur le substrat.

La substance 72 se présente alors sous forme de liquide ou de pâte, à laquelle des particules peuvent être ajoutées avant sa dispense afin de fonctionnaliser les connecteurs, dont les fonctions sont électriques, thermiques, optiques, piézoélectriques et/ou mécaniques. A titre d'exemples indicatifs, pour des connecteurs électriques et/ou thermiques, les particules ajoutées peuvent être du noir de carbone, des nanotubes de carbone, du graphène, de fibres telles que des fibres de carbone, d'acier d'aluminium, de cuivre, des poudres métalliques, des oxydes de métaux.

Par ailleurs, il est indiqué que la substance est retenue de manière à ce qu'elle permette une certaine souplesse du cordon lors du transfert sur le substrat, afin de supporter la flexion lors du passage de la zone de transfert au substrat, et ce en raison de l'inclinaison A du substrat par rapport à la direction horizontale. Cette souplesse doit donc subsister après la polymérisation partielle ou totale du cordon dans la zone de transfert, avant le transfert sur le substrat. Cela présente également un intérêt lorsque le substrat est souple.

De préférence, la substance 72 présente un caractère hydrophobe à l'état liquide, pour que celui-ci reste en surface du liquide porteur après sa dispense sur le film de particules 4, si la substance atteint cette même surface du liquide porteur. Quoi qu'il en soit, la substance 72, après son dépôt sur le film, adhère à ce dernier en raison de sa composition. De plus, la substance est également choisie de manière à rester insoluble dans le liquide porteur à l'état liquide, et également à l'état solide après polymérisation.

Sur la figure 7c, le connecteur de gauche 74 présente la particularité de relier la surface supérieure d'un premier objet 50, et la surface inférieure d'un second objet 50.

Selon une autre réalisation également envisageable, schématisée sur la figure 7d, les connecteurs 74 sont déposés de manière à relier deux objets 50 empilés. Cela permet la construction de dispositifs en trois dimensions avant le transfert sur le substrat, grâce aux connecteurs reliant la surface inférieure d'un objet quelconque de l'empilement, à la surface supérieure de l'objet se situant directement en dessous dans ce même empilement. Les connecteurs 74 remplissent ici au moins une fonction mécanique de support de l'objet supérieur.

Selon encore une autre réalisation montrée sur la figure 7e, des connecteurs 74 sont réalisés sur la surface inférieure d'objets 50 à déposer, toujours en procédant au dépôt de la substance sur le film de particules 4, avant le dépôt des objets sur les cordons/points réalisés avec la substance 72. Par ailleurs, des orifices traversants 76 sont pratiqués sur le substrat 38. Le dépôt/tirage est ensuite réalisé de telle sorte que les connecteurs 74 se logent automatiquement dans les orifices 76 correspondants lors du transfert sur le substrat 38. Après ce transfert, la partie inférieure des connecteurs 74 se retrouve donc accessible depuis la surface du substrat opposée à celle sur laquelle le dépôt a été réalisé, cette partie inférieure 74 continuant éventuellement à porter des particules 4 non gênantes pour la connectique.

Comme évoqué ci-dessus, après le dépôt, la largeur de ce film 4' intégrant les objets 50 correspond à la largeur L1 de la sortie 26, même si une largeur inférieure peut être adoptée, sans sortir du cadre de l'invention.

De façon encore plus préférée, le substrat est directement au contact de la sortie des particules.

Les particules ordonnées 4 recouvrant toute la surface du liquide porteur 16 présent dans la zone de transfert, l'ordonnancement est ainsi conservé jusqu'au moment du dépôt à la sortie 26 de la zone 14. La conservation de cet ordonnancement assure le maintien d'un positionnement relatif précis entre les objets 50, ainsi qu'une position précise par rapport aux rebords latéraux fixes 28, jusqu'à ce que ces objets 50 munis de leurs connecteurs 74 soient déposés/transférés sur le substrat avec les particules 4.

Pour faciliter le dépôt et l'adhérence des particules 4 et des objets 50 sur le substrat, de préférence réalisé en polymère, il est prévu un recuit thermique postérieurement au transfert. Ce recuit thermique est par exemple réalisé à 80°C, en utilisant un film mat de laminage basse température à base de polyester, par exemple commercialisé sous la référence PERFEX-MATT™, d'épaisseur 125µm.

L'avantage d'un tel film en tant que substrat est que l'une de ses faces devient collante à la température de l'ordre de 80°C, ce qui permet de faciliter l'adhérence des particules 4 et des objets 50 sur celle-ci. Cette température étant relativement basse par rapport aux températures d'élaboration des objets visés par l'invention comme les puces en silicium ou les cellules photovoltaïques, la fixation de ces objets peut s'effectuer sans détérioration.

Plus précisément, à cette température, les particules 4 s'enfoncent dans le film ramolli 38, et permettent ainsi un contact direct des objets avec le film, qui conduit à leur collage.

Alternativement, le substrat 38 peut être du type silicium, verre, ou encore film piézoélectrique.

Au cours du transfert, l'injection de particules et la vitesse de défilement du substrat sont réglées de sorte que le front de particules reste dans une position sensiblement identique. Pour ce faire, le débit de particules peut être de l'ordre de 0,1 ml/min à plusieurs ml/min, tandis que la vitesse linéaire du substrat 38, également dénommée vitesse de tirage, peut être de l'ordre de quelques mm/min à plusieurs centaines de mm/min. Bien entendu, les objets 50 et la substance 72 sont déposés au fur et à mesure sur le film de particules ordonnées 4, dans la zone de transfert 14, avant que l'ensemble formé par ces éléments n'atteigne le substrat 38 sur lequel il est ensuite déposé/transféré.

Les objets à transférer peuvent être de différentes sortes, en fonction des applications désirées. Préférentiellement, chaque objet 50 présente une grande dimension supérieure à 0,2 cm et inférieure ou égale à L1, c'est-à-dire proche 30 cm. L'épaisseur est comprise entre une dizaine de micromètres et plusieurs dizaines de millimètres.

Certains types d'objets à transférer comme les cellules solaires, micro-batteries et composants organiques ont une forme simple de carré, de rectangle, ou encore de disque, avec une faible épaisseur, et une superficie de l'ordre de 0,1 à 100 cm².

Ces composants peuvent comporter des plots ou pinoches sur la face en contact avec le liquide pour procéder à leur connectique. D'autres types objets, visant par exemple la détection d'éléments, la génération d'énergie ou encore le transport de l'information, peuvent avoir des formes complexes, par exemple des parties courbés ou en spirale.

Par ailleurs, le rapport entre la grande dimension des particules 4 et celle des objets 50 à transférer est préférentiellement compris entre 10⁴ et 10⁸. En effet, la grande dimension des particules est par exemple de l'ordre de 1 nm à 500 µm, tandis que les objets convoyés 50 peuvent présenter une grande dimension allant jusqu'à environ 30 cm.

De préférence, la face de chaque objet 50 au contact du liquide porteur est à caractère hydrophobe, mais il est également possible de prévoir un agencement de parties hydrophiles et hydrophobes au niveau de cette face. Comme évoqué ci-dessus, la tension superficielle du liquide porteur joue aussi un rôle important dans la flottaison de ces objets.

Le tableau ci-dessous recense quelques exemples préférés pour ces objets 50.

| **Nature** | **Dimensions** | **Domaine d**'**application** |
|---|---|---|
| Polyéthylène téréphtalate (PET) avec couche d'or structurée en surface | PET : 3x4cm² ; épaisseur 250µm ; PET : 1,5x0,9cm² ; épaisseur 250µm, Au : épaisseur 30nm | Electronique organique |
| Verre avec cellule photovoltaïque en surface | 25x25mm² ; épaisseur 1,08mm | Cellule Photovoltaïque |
| Puce en silicium | 3x3cm² ; épaisseur 500µm 1x1cm² ; épaisseur 500µm | Electronique |
| Micro-batterie sur silicium | 1x1cm² ; épaisseur 500µm | Stockage énergie |
| Matériau métallique bilame (ex. : zinc/cuivre) | 3,5x2cm² ; épaisseur 140µm 5x1,6cm² ; épaisseur 200µm 7x1,6cm² ; épaisseur 200µm | Thermique, capteurs |

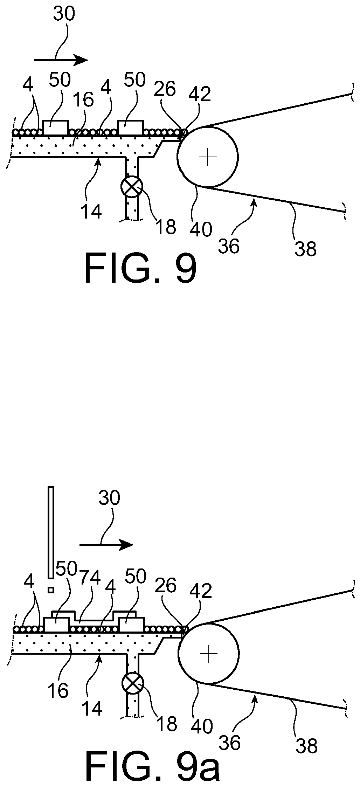

En référence à présent aux figures 8 et 9, il est schématisé des étapes d'un procédé de transfert d'objets selon un autre mode de réalisation.

Ce procédé se distingue du précédent par le fait que les objets 50 ne sont pas posés sur le film de particules ordonnées 4, mais flottent sur le liquide porteur 16 en étant entourés par ce même film. Ici, les objets 50 sont alors préférentiellement placés sur le liquide porteur avant la formation du film compact de particules, qui se constitue ensuite autour de ces objets de manière à les maintenir en position en les enserrant à leur périphérie. Les objets présentent ainsi une surface inférieure directement en contact avec le liquide porteur. Dans ce mode de réalisation, c'est également le film de particules ordonnées qui permet de maintenir les objets en position et de les transporter de façon ordonnée jusqu'au substrat sur lequel ces derniers doivent être déposés.

Les autres étapes du procédé sont analogues à celles décrites pour le procédé précédent, en particulier celle relative à la formation des connecteurs 74 schématisée sur la figure 9a.

Enfin, la figure 10 représente une autre installation 1 de transfert d'objet, qui se différencie de la précédente essentiellement par le fait que le substrat en défilement 38 est rigide. Sur cette figure, les éléments portant des références identiques à celles portées sur des éléments des figures précédentes correspondent à des éléments identiques ou similaires.

Comme évoqué ci-dessus, plusieurs solutions sont possibles pour le dépôt des objets 50. Parmi les solutions préférées, il existe celle consistant à prévoir un ou plusieurs convoyeurs pour le transport de ces objets vers la zone de transfert. Naturellement, bien que cela n'ait pas été représenté, ces techniques sont prévues en sus de celle permettant la dépose de la substance pour l'obtention des différents connecteurs sur les objets 50.

Chaque convoyeur 60 est de préférence parallèle à la rampe 12, comme cela est montré sur la figure 11a. Le convoyeur 60, fixe ou mobile, peut être réalisé de toute manière réputée appropriée par l'homme du métier, typiquement à l'aide d'un ruban ou d'une succession de rouleaux. Les objets sont ainsi transportés et déposés par le convoyeur 60 à une cadence déterminée en fonction de l'agencement désiré de ces objets par rapport au film de particules 4.

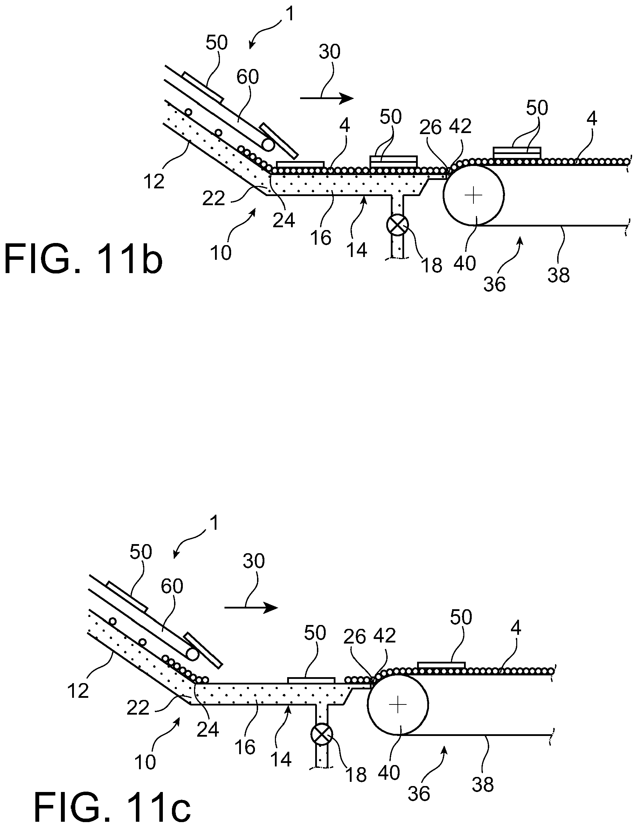

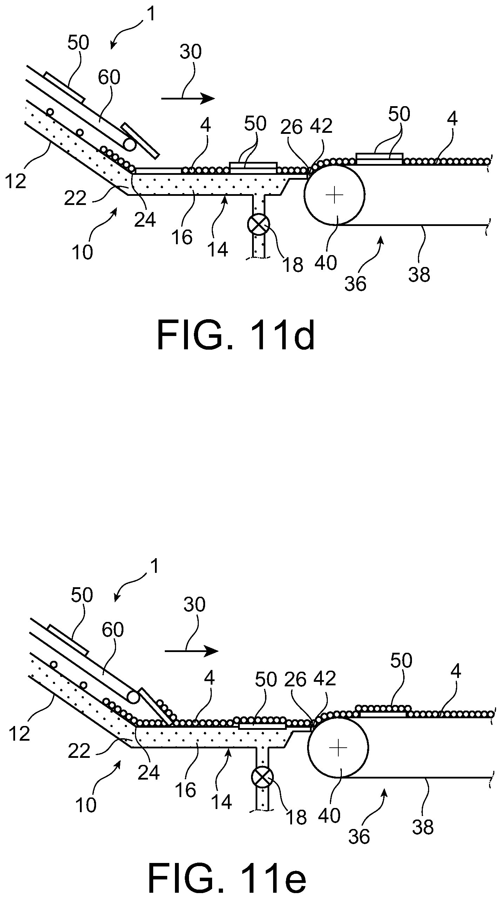

D'ailleurs, avec cette technique, il est non seulement possible de déposer les objets 50 sur le film de particules 4 comme montré sur la figure 11a, mais également directement sur le liquide porteur 16 avant que les particules 4 ne viennent les entourer dans la zone de transfert 14, comme cela a été schématisé sur la figure 11c. Alternativement, il est aussi possible de déposer les objets 50 sur d'autres objets similaires, comme cela a été représenté sur les figures 11b et 11d. Sur la figure 11b, les objets 50 sont déposés sur d'autres objets 50 eux-mêmes posés sur le film de particules, tandis que sur l'exemple de la figure 11d, les objets 50 sont déposés sur d'autres objets 50 déjà intégrés au film de particules 4.

Enfin, parmi ces solutions de dépôt d'objets dites « au déroulé », il possible de faire en sorte que les objets 50 s'échappant du convoyeur 60 perforent le film de manière à se glisser sous ce dernier, comme montré sur la figure 11e. Après stabilisation, chaque objet 50 flottant sur le liquide porteur 16 est bien maintenu par les particules 4 du film qui l'entoure.

Associé au convoyeur 60, un module de vision (non représenté) avec logiciel de traitement d'image peut suivre en temps réel le déplacement des objets sur le convoyeur 60, le transfert de ces éléments, et enfin le tirage de l'ensemble sur le substrat. Ce module de vision peut également calculer les écarts géométriques entre les objets déposés sur le film compact, et éventuellement comparer ces écarts à un schéma théorique préprogrammé, de manière à valider le bon positionnement des objets déposés.

## Revendications

1. Procédé de transfert d'objets (50) sur un substrat (38), de préférence en défilement, **caractérisé en ce qu'**il est mis en oeuvre à l'aide d'une zone de transfert (14) contenant un liquide porteur (16) formant convoyeur, lesdits objets (50) étant maintenus par un film compact de particules (4) flottant sur le liquide porteur (16) de cette zone de transfert, au sein de laquelle lesdits objets (50) sont déplacés avec ledit film de particules (4) de manière à être transférés sur le substrat (38) lorsqu'ils atteignent la sortie (26),
ledit procédé comprenant également la réalisation d'au moins un connecteur (74) en contact avec au moins l'un desdits objets (50), ledit connecteur étant réalisé à l'aide d'une substance comprenant un composé polymérisable (72), mise au contact dudit objet agencé au sein de la zone de transfert (14), puis par polymérisation de ladite substance (72).

2. Procédé selon la revendication 1, dans lequel au moins un connecteur (74) est réalisé entre au moins deux desdits objets (50), à l'aide de ladite substance comprenant un composé polymérisable (72), appliquée sur le film de particules (4) de manière à relier les deux objets (50) espacés l'un de l'autre au sein de la zone de transfert (14), puis par polymérisation de ladite substance.

3. Procédé selon la revendication 1 ou la revendication 2, dans lequel au moins un connecteur (74) est réalisé entre au moins deux desdits objets (50) destinés à être empilés l'un sur l'autre, à l'aide de ladite substance comprenant un composé polymérisable (72), appliquée sur l'un desdits objets agencé au sein de la zone de transfert (14), puis par polymérisation de ladite substance.

4. Procédé selon l'une quelconque des revendications précédentes, dans lequel ledit substrat (38) est pourvu d'au moins un orifice traversant (76), destiné à loger au moins un connecteur (74) réalisé entre la surface inférieure d'un objet (50) et le film compact de particules (4).

5. Procédé selon l'une quelconque des revendications précédentes, dans lequel ledit connecteur (74) est un connecteur électrique, thermique, optique, piézoélectrique ou mécanique.

6. Procédé selon l'une quelconque des revendications précédentes, dans lequel au moins un connecteur (74) épouse une surface supérieure d'au moins l'un des objets.

7. Procédé selon l'une quelconque des revendications précédentes, dans lequel au moins un connecteur (74) épouse une surface inférieure d'au moins l'un des objets, en étant interposé entre cette surface inférieure et le film compact de particules (4).

8. Procédé selon l'une quelconque des revendications précédentes, dans lequel ladite substance (72) se présente sous la forme d'un liquide ou d'une pâte.

9. Procédé selon l'une quelconque des revendications précédentes, dans lequel ladite substance (72) présente un caractère hydrophobe.

10. Procédé selon l'une quelconque des revendications précédentes, dans lequel ladite substance (72) est à base de résine silicone, de résine époxy, et/ou de résine polyuréthane.

11. Procédé selon l'une quelconque des revendications précédentes, dans lequel ladite substance (72) comprend au moins certaines particules prises parmi les matériaux suivants :
- noir de carbone ;
- nanotubes de carbone ;
- graphène
- fibres, telles que des fibres de carbone, d'acier d'aluminium, de cuivre ;
- poudres métalliques ; et
- des oxydes de métaux.

12. Procédé selon l'une quelconque des revendications précédentes, **caractérisé en ce qu'**au moins l'un des objets à transférer (50) est placé dans la zone de transfert (14), en flottaison sur le liquide porteur (16) formant convoyeur, de manière à être entouré par le film de particules.

13. Procédé selon l'une quelconque des revendications précédentes, **caractérisé en ce qu'**au moins l'un des objets (50) à transférer est placé dans la zone de transfert (14) sur le film compact de particules (4) préalablement formé, de manière à créer, dans le liquide porteur (16), un enfoncement des particules qui le supportent.

14. Procédé selon l'une quelconque des revendications précédentes, **caractérisé en ce que** chaque objet (50) à transférer présente une grande dimension supérieure à 0,2 cm.

15. Procédé selon l'une quelconque des revendications précédentes, **caractérisé en ce que** chaque objet (50) à transférer est un élément pris parmi le groupe des puces en silicium, des micro-batteries, des composants de l'électronique organique, des éléments métalliques, des cellules photovoltaïques, des piles et micro-piles.

16. Procédé selon l'une quelconque des revendications précédentes, **caractérisé en ce qu'**il met en oeuvre une rampe inclinée (12) de circulation des particules, rattachée à une entrée de la zone de transfert, et sur laquelle ledit liquide porteur (16) est également destiné à circuler.

## Patentansprüche

1. Verfahren zum Überführen von Objekten (50) auf ein vorzugsweise vorbeilaufendes Substrat (38), **dadurch gekennzeichnet, dass** es mit Hilfe eines Überführungsbereichs (14) durchgeführt wird, der eine Trägerflüssigkeit (16) enthält, die ein Fördermittel bildet, wobei die Objekte (50) von einem kompakten Partikelfilm (4) gehalten werden, der auf der Trägerflüssigkeit (16) dieses Überführungsbereichs schwimmt, innerhalb dessen die Objekte (50) mit dem Partikelfilm (4) so verlagert werden, dass sie auf das Substrat (38) überführt werden, wenn sie den Auslass (26) erreichen,
wobei das Verfahren auch das Herstellen von zumindest einem Verbinder (74) in Kontakt mit zumindest einem der Objekte (50) umfasst, wobei der Verbinder mit Hilfe einer Substanz, die eine polymerisierbare Verbindung (72) enthält und mit dem innerhalb der Überführungsbereichs (14) angeordneten Objekt in Kontakt gebracht wird, und dann durch Polymerisation der Substanz (72) hergestellt wird.

2. Verfahren nach Anspruch 1, wobei zumindest ein Verbinder (74) zwischen zumindest zwei der Objekte (50) mit Hilfe der Substanz, die eine polymerisierbare Verbindung (72) enthält und auf den Partikelfilm (4) so aufgebracht ist, dass sie die beiden voneinander beabstandeten Objekte (50) innerhalb des Überführungsbereichs (14) verbindet, dann durch Polymerisation der Substanz hergestellt wird.

3. Verfahren nach Anspruch 1 oder Anspruch 2, wobei zumindest ein Verbinder (74) zwischen zumindest zwei der Objekte (50), die dazu bestimmt sind, aufeinandergestapelt zu werden, mit Hilfe der Substanz, die eine polymerisierbare Verbindung (72) enthält und auf eines der Objekte innerhalb des Überführungsbereichs (14) aufgebracht wird, dann durch Polymerisation der Substanz hergestellt wird.

4. Verfahren nach einem der vorangehenden Ansprüche, wobei das Substrat (38) mit zumindest einer durchgehenden Öffnung (76) versehen ist, die dazu bestimmt ist, zumindest einen Verbinder (74) aufzunehmen, der zwischen der Unterseite eines Objekts (50) und dem kompakten Partikelfilm (4) ausgebildet ist.

5. Verfahren nach einem der vorangehenden Ansprüche, wobei der Verbinder (74) ein elektrischer, thermischer, optischer, piezoelektrischer oder mechanischer Verbinder ist.

6. Verfahren nach einem der vorangehenden Ansprüche, wobei zumindest ein Verbinder (74) sich an eine Oberseite von zumindest einem der Objekte anschmiegt.

7. Verfahren nach einem der vorangehenden Ansprüche, wobei zumindest ein Verbinder (74) sich an eine Unterseite von zumindest einem der Objekte anschmiegt, indem er zwischen dieser Unterseite und dem kompakten Partikelfilm (4) eingesetzt ist.

8. Verfahren nach einem der vorangehenden Ansprüche, wobei die Substanz (72) in Form einer Flüssigkeit oder einer Paste vorliegt.

9. Verfahren nach einem der vorangehenden Ansprüche, wobei die Substanz (72) eine hydrophobe Eigenschaft hat.

10. Verfahren nach einem der vorangehenden Ansprüche, wobei die Substanz (72) auf Basis von Silikonharz, Epoxidharz und/oder Polyurethanharz besteht.

11. Verfahren nach einem der vorangehenden Ansprüche, **dadurch gekennzeichnet, dass** die Substanz (72) zumindest bestimmte Partikel, ausgewählt aus den folgenden Materialien, enthält:
- Ruß;
- Kohlenstoffnanoröhrchen;
- Graphen;
- Fasern, wie etwa Fasern aus Kohlenstoff, aus Aluminium, aus Stahl, aus Kupfer;
- Metallpulver; und
- Metalloxide.

12. Verfahren nach einem der vorangehenden Ansprüche, **dadurch gekennzeichnet, dass** zumindest eines der zu überführenden Objekte (50) in dem Überführungsbereich (14) auf der das Fördermittel bildenden Trägerflüssigkeit schwimmend angeordnet ist, so dass es von dem Partikelfilm umgeben wird.

13. Verfahren nach einem der vorangehenden Ansprüche, **dadurch gekennzeichnet, dass** zumindest eines der zu überführenden Objekte (50) in dem Überführungsbereich (14) auf dem zuvor ausgebildeten kompakten Partikelfilm (4) so angeordnet wird, so dass es in der Trägerflüssigkeit (16) eine Vertiefung der dieses tragenden Partikel erzeugt.

14. Verfahren nach einem der vorangehenden Ansprüche, **dadurch gekennzeichnet, dass** jedes zu überführende Objekt (5) eine große Abmessung größer als 0,2 cm aufweist.

15. Verfahren nach einem der vorangehenden Ansprüche, **dadurch gekennzeichnet, dass** jedes zu überführende Objekt (50) ein Element aus der Gruppe umfassend Silicium-Chips, Mikroakkus, Bauteile der organischen Elektronik, metallische Elemente, Solarzellen, Batterien und Mikro-Batterien ist.

16. Verfahren nach einem der vorangehenden Ansprüche, **dadurch gekennzeichnet, dass** es eine geneigte Rampe (12) zur Zirkulation von Partikeln verwendet, die mit einem Einlass des Überführungsbereichs verbunden ist und auf welcher auch die Trägerflüssigkeit (16) zirkulieren soll.

## Claims

1. A method for transferring objects (50) onto a substrate (38), preferably running, **characterized in that** it is executed by means of a transfer area (14) containing a carrier liquid (16) forming a conveyor, said objects (50) being held by a compact film of particles (4) floating on the carrier liquid (16) of this transfer area, within which said objects (50) are displaced with said film of particles (4) so as to be transferred onto the substrate (38) when they reach the outlet (26),
said method also comprising making at least one connector (74) in contact with at least one of said objects (50), said connector being made by means of a substance comprising a polymerisable compound (72), placed in contact with said object arranged within the transfer area (14), then by polymerization of said substance (72).

2. The method according to claim 1, wherein at least one connector (74) is made between at least two of said objects (50), by means of said substance comprising a polymerisable compound (72), applied to the film of particles (4) so as to connect the two objects (50) spaced apart from each other within the transfer area (14), then by polymerization of said substance.

3. The method according to claim 1 or claim 2, wherein at least one connector (74) is made between at least two of said objects (50) intended to be stacked on each other by means of said substance comprising a polymerisable compound (72) applied to one of said objects arranged within the transfer area (14), then by polymerization of said substance.

4. The method according to any one of the preceding claims, wherein said substrate (38) is provided with at least one through-hole (76) intended to house at least one connector (74) made between the lower surface of an object (50) and the compact film of particles (4).

5. The method according to any one of the preceding claims, wherein said connector (74) is an electric, thermal, optical, piezoelectric or mechanical connector.

6. The method according to any one of the preceding claims, wherein at least one connector (74) matches an upper surface of at least one of the objects.

7. The method according to any one of the preceding claims, wherein at least one connector (74) matches a lower surface of at least one of the objects by being interposed between this lower surface and the compact film of particles (4).

8. The method according to any one of the preceding claims, wherein said substance (72) is in the form of liquid or paste.

9. The method according to any one of the preceding claims, wherein said substance (72) has a hydrophobicity.

10. The method according to any one of the preceding claims, wherein said substance (72) is based on silicone resin, epoxy resin, and/or polyurethane resin.

11. The method according to any one of the preceding claims, wherein said substance (72) comprises at least some particles taken from the following materials:
- carbon black;
- carbon nanotubes;
- graphene;
- fibers, such as carbon, steel, aluminium, copper fibers;
- metal powders; and
- metal oxides.

12. The method according to any one of the preceding claims, **characterized in that** at least one of the objects (50) to be transferred is placed in the transfer area (14), floating on the carrier liquid (16) forming a conveyor so as to be enclosed by the film of particles.

13. The method according to any one of the preceding claims, **characterized in that** at least one of the objects (50) to be transferred is placed in the transfer area (14) on the compact film of particles (4) previously formed so as to create in the carrier liquid (16) depression of particles which support it.

14. The method according to any one of the preceding claims, **characterized in that** each object (50) to be transferred has a large dimension greater than 0.2 cm.

15. The method according to any one of the preceding claims, **characterized in that** each object (50) to be transferred is an element taken from the group of silicon chips, micro-battery cells, components of organic electronics, metallic elements, photovoltaic cells, battery cells and micro-battery cells.

16. The method according to any one of the preceding claims, **characterized in that** it uses an tilted ramp (12) for circulation of particles, attached to an inlet of the transfer area, and on which said carrier liquid (16) is also intended to circulate.
